# DEMANDE DE BREVET EUROPEEN

(11) **EP 1 045 524 A1**
(43) Date de publication de la demande: **18.10.2000**
(21) Numéro de dépôt: 00401010.4
(22) Date de dépôt: 12.04.2000
(51) Int. Cl.: H04B 1/30, H03D 11/00

(54) **Récepteur radio-fréquence basse consommation**

(30) Priorité: 14.04.1999 FR 9904649
(71) Demandeur: Valeo Electronique, 94042 Créteil (FR)
(72) Inventeur: Courjault, Gilles, 78114 Magny les Hameaux (FR); Farine, Hervé, 94210 La Varenne st. Hilaire (FR); Belinguier, Thierry, 94410 Saint-Maurice (FR)

(57) **Abrégé**

Récepteur radio-fréquence comportant un oscillateur (1) qui comprend un transistor (T1) qui est commandé par la superposition d'un signal (IC) qui permet le démarrage périodique dudit oscillateur (1), ainsi que d'un signal haute fréquence (RF) à détecter, caractérisé en ce que ce signal périodique (IC) est un signal impulsionnel, l'énergie des impulsions de ce signal étant choisie pour être juste supérieure à l'énergie nécessaire au démarrage de l'oscillateur et en ce qu'il comporte des moyens d'amplification haute fréquence (3) en sortie de l'oscillateur (1), ainsi que des moyens (4) pour restituer la modulation d'amplitude du signal en sortie de ces moyens d'amplification.

## Description

La présente invention est relative à un récepteur radio-fréquence basse consommation.

L'invention trouve en particulier avantageusement application dans les systèmes de commande à distance qui permettent de réaliser le verrouillage/déverrouillage "mains libres" d'ouvrants de véhicules automobiles (portières, coffre), c'est à dire un verrouillage/déverrouillage sans actionnement d'un boîtier de télécommande par l'opérateur.

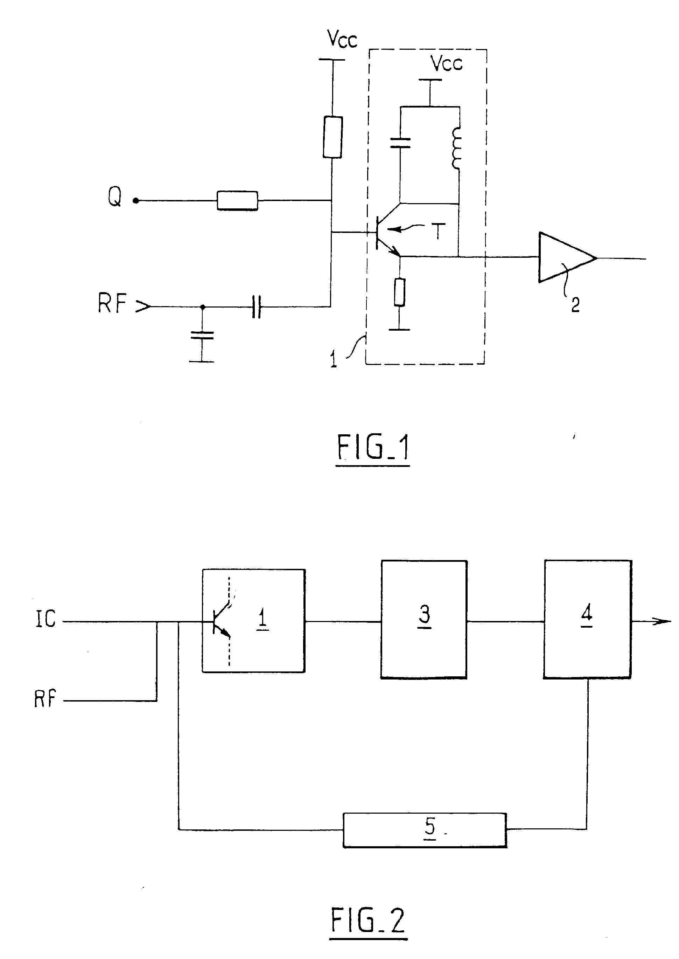

On connaît depuis longtemps des récepteurs présentant une structure dite à "super-réaction" comportant, ainsi qu'illustré sur la figure 1, un oscillateur 1 qui reçoit en entrée un signal RF haute fréquence qui est modulé en amplitude (modulation ASK ou OOK, par exemple).

Cet oscillateur 1 est allumé puis éteint au rythme d'un signal Q périodique appelé signal "quench" qui est d'une fréquence bien inférieure au signal RF. Ce signal quench est superposé au signal RF et est injecté avec celui-ci sur la base d'un transistor T intégré à l'oscillateur 1.

Le signal quench peut être généré par un oscillateur indépendant (on parle alors d'un montage à quench externe) ou être généré par la relaxation de l'oscillateur 1 (on parle alors d'un montage auto quench).

Avec un montage à quench externe, l'amplitude du signal RF en sortie de l'oscillateur 1 est proportionnelle à l'énergie du signal capté sur son entrée. Avec les montages à auto-quench, la fréquence du signal de quench varie avec l'énergie du signal RF capté sur son entrée.

Dans l'un et l'autre cas, le signal démodulé est restitué par un amplificateur 2 basse fréquence en sortie du montage.

Ce type de récepteur est très répandu et répond à la plupart des besoins des récepteurs fonctionnant en veille permanente pour recevoir des signaux modulés en amplitude avec un débit moyen de 1 à 2 Kbit/s.

Toutefois, les récepteurs à quench externe ou à auto-quench connus à ce jour sont alimentés sous une tension de 2 à 5 volts et présentent une consommation en courant de l'ordre de 100 à 400 µA.

Un but de l'invention est de proposer un récepteur radio-fréquence qui présente une consommation beaucoup plus faible, tout en étant en permanence sous tension et en permettant des temps de réaction courts.

A cet effet, l'invention propose un récepteur radio-fréquence comportant un oscillateur qui comprend un transistor qui est commandé par la superposition d'un signal qui permet le démarrage périodique dudit oscillateur, ainsi que d'un signal haute fréquence à détecter, caractérisé en ce que ce signal périodique est un signal impulsionnel. L'énergie des impulsions de ce signal est choisie pour être juste supérieure à l'énergie nécessaire au démarrage de l'oscillateur et le récepteur comporte des moyens d'amplification haute fréquence en sortie de l'oscillateur, ainsi que des moyens pour restituer la modulation d'amplitude du signal en sortie de ces moyens d'amplification.

Comme on l'aura compris, le contrôle du signal périodique permet de réduire au maximum le courant de consommation de l'oscillateur.

Ce récepteur est avantageusement complété par les différentes caractéristiques suivantes prises seules ou selon toutes leurs combinaisons techniquement possibles :
- le récepteur comporte des moyens d'asservissement permettant, en présence d'un signal haute fréquence en sortie des moyens d'amplification, de démarrer plus tôt l'oscillateur ;
- les moyens pour restituer la modulation d'amplitude du signal en sortie des moyens d'amplification comportent deux comparateurs, l'un qui délivre un signal démodulé, l'autre qui délivre un signal qui, en présence d'un signal haute fréquence en sortie des moyens d'amplification, charge un condensateur que comportent les moyens d'asservissement et qui en l'absence de ce signal haute fréquence décharge ledit condensateur ;
- le récepteur comporte un filtre passe bas en sortie des moyens d'amplification haute fréquence ;
- les moyens d'amplification sont constitués par un amplificateur à émetteur commun ;
- les moyens d'amplification comportent un montage à deux transistors auto-polarisés ;
- le signal périodique impulsionnel présente une période d'une durée de l'ordre de 40 µs à 50 µs ;
- la durée d'une impulsion du signal impulsionnel est de l'ordre de 1,5 µs ;
- le signal périodique impulsionnel est généré par des moyens indépendant de l'oscillateur.

L'invention concerne également un système main libre pour une commande à distance sur un véhicule automobile, caractérisé en ce qu'il comporte un tel récepteur.

D'autres caractéristiques et avantages de l'invention ressortiront encore de la description qui suit. Cette description est purement illustrative et non limitative. Elle doit être lue en regard ces dessins annexés, sur lesquels :
- la figure 1, déjà analysée, représente schématiquement un récepteur constitué d'un oscillateur RF commandé par un signal quench connu de l'état de la technique ;
- la figure 2 illustre schématiquement un récepteur conforme à un mode de réalisation de l'invention ;
- la figure 3 est un schéma d'un montage possible pour le récepteur de la figure 2 ;
- la figure 4 est un schéma d'un autre montage d'amplification/détection possible pour le récepteur de la figure 1 ;
- la figure 5 est un graphe illustrant l'évolution dans le temps du signal en entrée et du signal en sortie du montage de la figure 4.

Le récepteur représenté sur la figure 2 comporte un oscillateur 1 à montage à super-réaction qui intègre un transistor d'entrée T₁ qui est commandé par une tension qui est la superposition d'un signal RF à détecter et démoduler (par exemple d'une fréquence de 433, 92 MHz) et d'un signal IC de commande qui est un signal impulsionnel.

Ce signal IC de commande est généré par des moyens indépendants de l'oscillateur 1. Il est choisi de façon que chacune de ses impulsions permette tout juste le démarrage de l'oscillateur RF et son fonctionnement pendant un très court instant, sans que l'oscillateur n'atteigne son fonctionnement oscillatoire permanent.

Par signal impulsionnel, on entend un signal de commande dont le rapport cyclique est très inférieur à 50%. Par exemple, la durée d'une impulsion de ce signal est de 1,5 µs, tandis que sa période est de 40 µs.

L'oscillateur 1 étant éteint entre deux impulsions, la consommation du récepteur se trouve réduite.

Toutefois, du fait que l'oscillateur 1 est commandé par un signal impulsionnel et non pas par un signal quench classique présentant un rapport cyclique supérieur à 50 %, l'amplitude du signal en sortie de l'oscillateur n'est pas proportionnelle à l'énergie du signal RF d'entrée. Un amplificateur basse fréquence en sortie de l'oscillateur ne permet pas de restituer directement le signal utile.

Le récepteur représenté sur la figure 2 comporte quant à lui en sortie de l'oscillateur 1 un étage 3 d'amplification haute fréquence, qui est interposé entre la sortie de l'oscillateur 1 et un étage 4 qui constitue un filtre passe-bas pour la remise en forme des signaux en sortie de l'étage 3.

Le récepteur comporte également des moyens 5 qui définissent une boucle d'asservissement qui permet de commander le transistor T de façon à le polariser lorsqu'un signal RF est détecté au niveau de l'étage 4.

Grâce à cette boucle d'asservissement 5, en présence d'un signal RF en entrée du récepteur, l'oscillateur 1 démarre plus vite, ce qui permet d'obtenir une forte amplitude de signal en sortie de l'étage 3 d'amplification haute fréquence. Par contre, en l'absence de signal RF sur l'entrée du récepteur, les impulsions du signal de commande IC ne génèrent que des débuts d'oscillations sur l'oscillateur, de sorte que la consommation du récepteur est limitée.

Ainsi, l'énergie consommée est réduite.

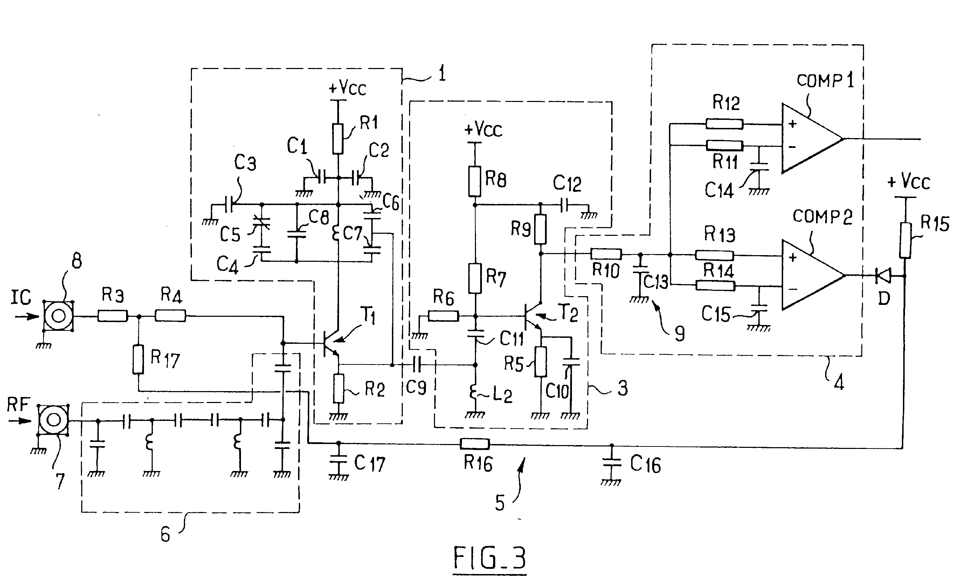

Les différents étages du récepteur vont maintenant être décrits de façon détaillée en référence à la figure 3.

L'oscillateur 1 est un oscillateur de type LC.

Il comporte une résistance R1 qui est montée entre une borne d'alimentation à une tension continue V_{cc}, trois condensateurs C1 à C3 montés en parallèle l'un à l'autre entre la masse et l'extrémité de ladite résistance R1 qui est opposée à l'alimentation Vcc, ainsi qu'une inductance L1, qui est montée en parallèle avec des moyens capacitifs entre d'une part le point commun aux trois condensateurs C1 à C3 et la résistance R1 et d'autre part le collecteur d'un transistor T1 de type NPN, dont la fermeture permet l'oscillation de l'oscillateur 1.

Les moyens capacitifs précités qui sont montés en parallèle avec l'inductance L1 comportent un condensateur C8 monté en parallèle avec une branche qui comporte un condensateur C4 en série avec un condensateur à capacité réglable C5. Ils comportent en outre deux condensateurs C6 et C7 montés en série, le point commun entre lesdits condensateurs C6 et C7 étant quant à lui relié à l'émetteur du transistor T1

L'émetteur du transistor T1 est quant à lui relié à la masse par une résistance R2.

Les valeurs des impédances de ces différents composants sont les suivantes : R1 = 470 Ω, C1 = C3 = 100 pF, C2 = 1nF, L1 = 18 nH, C4 = 1,5 pF, C5 réglable entre 1,5 pF et 3 pF, C6 = C7 = 1,8 pF, C8 = 2,7 pF, R2 = 3,9 kΩ.

La base du transistor T1 est reliée à une borne d'alimentation 7 sur laquelle le signal RF à détecter est injecté, par l'intermédiaire d'un circuit de filtrage passe-bande 6.

Elle est reliée à une borne d'alimentation 8 recevant le signal de commande lC, par l'intermédiaire de deux résistances R3 et R4 en série.

La sortie de l'oscillateur 1 - que constitue l'émetteur du transistor T1 - est reliée par l'intermédiaire d'un condensateur de liaison C9 (de 4, 7 pF) à l'étage d'amplification 3.

Cet étage d'amplification 3 est constitué par un amplificateur à émetteur commun.

Il comporte un transistor T2 dont l'émetteur est relié à la masse par une résistance R5 et par un condensateur C10. La base de ce transistor T2 est reliée au condensateur C9 par l'intermédiaire d'un condensateur C11. Le point commun entre le condensateur C9 et le condensateur C11 est relié à la masse par l'intermédiaire d'une inductance L2. La base du transistor T2 est également reliée à la masse par l'intermédiaire d'une résistance R6. Elle est reliée par une résistance R7 à une résistance R8 qui est elle-même reliée à son extrémité opposée à une alimentation à la tension Vcc. A son extrémité opposée au transistor T2, la résistance R7 est reliée à la masse par l'intermédiaire d'un condensateur C12. Elle est également reliée au collecteur du transistor T2 par une résistance R9.

Le signal en sortie de cet étage 3 est la tension au collecteur du transistor T2.

Les valeurs des impédances des différents composants de cet étage 3 sont les suivantes : L2 = 330 nH, C10 = 1 nF, R5 = 300 kΩ, C11 = 1 nF, R6 = R7 = 1MΩ, R8 = 220 Ω, R9 = 470 kΩ, C12 = 270 pF.

L'étage 4 comporte un filtre passe bas 9 constitué par une résistance R10 (de 10 kΩ) reliée au collecteur du transistor T2, ainsi que par un condensateur C13 (de 10 pF) monté entre ladite résistance et la masse

Le signal ainsi filtré est transmis à un circuit de remise en forme de signal qui comporte deux comparateurs COMP1, COMP2.

La borne non inverseuse du comparateur COMP1 est reliée à la sortie du filtre passe bas par une résistance R11, tandis que son entrée non inverseuse est reliée à la sortie de ce filtre passe bas par une résistance R11, un condensateur C14 étant monté entre cette entrée inverseuse et la masse.

La sortie du comparateur COMP1 est à un niveau haut lorsqu'un signal oscillant est reçu du filtre passe bas et à un niveau bas sinon.

L'entrée non,inverseuse du comparateur COMP2 est reliée à la sortie du filtre passe bas 9 par une résistance R13, son entrée inverseuse est quant à elle reliée à la sortie du filtre passe-bas 9 par une résistance R14, ainsi qu'à la masse par l'intermédiaire d'un condensateur C15

La sortie de ce comparateur COMP2 est reliée par l'intermédiaire d'une diode D en série avec une résistance R15 à une alimentation à la tension Vcc. La diode D est passante de la résistance R15 vers le comparateur COMP2. Le point commun entre la diode D et la résistance R15 est relié à la masse par l'intermédiaire d'un condensateur C16 il est également relié au point commun entre les résistances R3 et R4 par l'intermédiaire de deux résistances R16 et R17 montées en série.

Le point commun entre la résistance R15 et la résistance R17 est quant à lui relié à la masse par l'intermédiaire d'un condensateur C17.

Avec la boucle d'asservissement ainsi constituée, le condensateur C16 se décharge en l'absence d'oscillations en sortie du filtre passe bas 9. L'oscillateur 1 est ainsi normalement éteint.

Lorsque le signal IC est à son niveau bas (0 Volt), le transistor T1 est bloqué. Lors de l'apparition d'une impulsion (niveau haut - 2 Volts), le réseau intégrateur (formé notamment des résistances R3 et R4) permet d'obtenir une rampe de tension sur la base du transistor T1. Dès que sa tension basse atteint 0,9 volt, le transistor T1 commence à conduire et permet le démarrage de l'oscillateur 1.

En l'absence de signal RF sur l'entrée que constitue la borne 7, l'oscillateur 1 n'atteint pas son plein niveau d'oscillation. L'énergie consommée est donc réduite.

En présence d'un signal RF sur l'entrée 7, le condensateur C16 se charge et le transistor T1 est plus rapidement passant. Ainsi, en présence d'un signal RF en entrée, l'oscillateur 1 démarre plus vite, ce qui permet d'obtenir une forte amplitude en sortie.

Le signal RF de l'oscillateur recueilli sur l'émetteur du transistor T1 est transmis (via le condensateur de liaison C9) à l'étage 4 d'amplification/détection RF.

Le signal dé sortie détecté est alors disponible sur le condensateur C13 et est appliqué à l'entrée du comparateur COMP2 dont les impulsions négatives de sortie viennent décharger le condensateur C16.

La tension aux bornes du condensateur C16 est intégrée et filtrée par le condensateur C17 pour permettre d'asservir le point de fonctionnement idéal de l'oscillateur 1 : plus la tension d'asservissement est élevée, plus l'oscillateur 1 démarre tôt et inversement.

A titre d'exemple, le signal RF peut être modulé à un débit de l'ordre de 1 Kbit/s, la durée d'un bit de niveau 1 à démoduler étant de 500µs (exemple code Manchester). Un tel signal est correctement démodulé avec une dizaine de points échantillons par bit de niveau 1, ce qui correspond à des périodes de 40 à 50 µs pour le signal IC.

Par rapport à un récepteur classique à signal quench permanent de même fréquence, la consommation de l'oscillateur est alors réduite d'un rapport 10.

D'autres variantes de réalisation sont bien entendu possibles, notamment pour l'étage 3 d'amplification/détection.

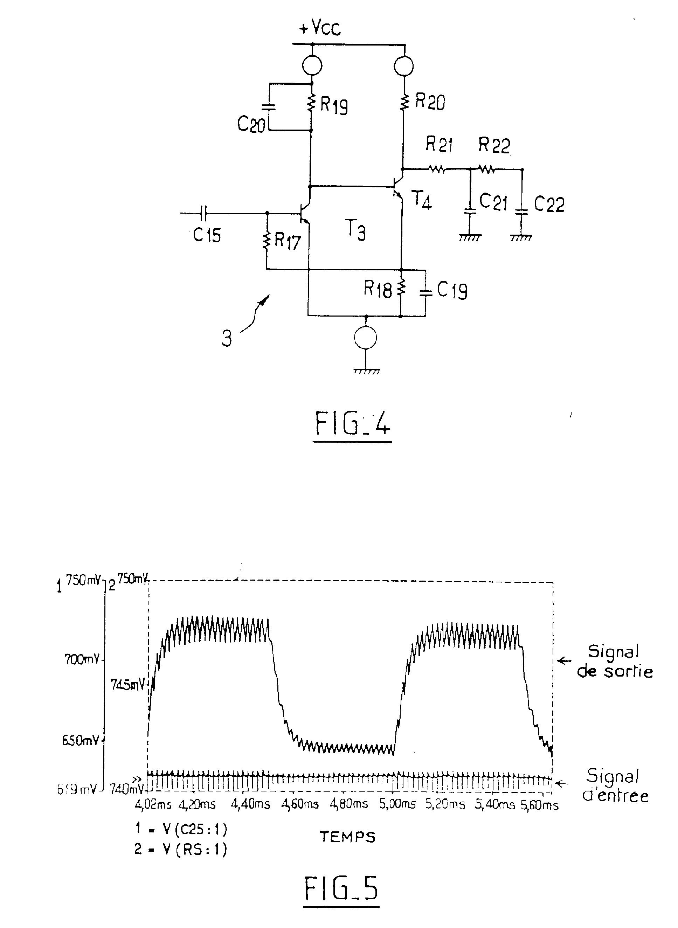

A titre d'exemple, un autre mode de réalisation possible a été représenté sur la figure 5.

Dans ce mode de réalisation, l'étage 3 comporte deux transistors auto-polarisés, ce qui confère au montage une très bonne robustesse vis à vis de la température.

Le signal en sortie de l'oscillateur est reçu, par l'intermédiaire du condensateur C18 (de 100 nF), sur la base d'un transistor T3 de type NPN. L'émetteur de ce transistor T3 est relié à la masse. La base de transistor T3 est également reliée à la masse par l'intermédiaire d'une résistance R17 (de 1k Ω) montée en série avec un condensateur C19 (de 1nF) monté en parallèle avec une résistance R18 (de 1 kΩ).

La base du transistor T3 est également reliée à une alimentation à la tension Vcc par l'intermédiaire d'une résistance R19 (de 1k Ω) montée en parallèle avec un condensateur C20 (de 1nF). Le collecteur de ce transistor T3 est relié quant à lui à la base d'un transistor T4 NPN dont l'émetteur est relié au point commun entre la résistance R17 et la résistance R18 en parallèle avec le condensateur C19.

Le collecteur de ce transistor T3 est relié à une alimentation à la tension Vcc par une résistance R20 (de 1k Ω).

La tension en sortie du collecteur du transistor T4 est filtrée par un filtre passe bas du second ordre qui est constitué de deux résistances en série R21 et R22 (chacune de 1kΩ) et de deux condensateurs C21 et C22 (chacun de 1nF) monté l'un entre le point commun aux résistances R21 et R22 et la masse, l'autre entre le point de la résistance 22 qui est le plus éloigné du transistor T4 et la masse.

Le signal entrant au niveau de la capacité C18 est amplifié et intégré par le transistor T3, le signal sur la base du transistor T4 ayant un niveau suffisant est ensuite détecté par la jonction base-émetteur du transistor T4 et amplifié.

Le courant résultant de cette détection est très riche en harmoniques. Le filtre passe-bas que constituent les composants R21, R22, C21, C22 permet de sélectionner les harmoniques utiles.

Comme on l'aura compris, le récepteur qui vient d'être décrit présente l'avantage de permettre une très faible consommation, tout en étant d'un faible coût.

Avantageusement, un tel récepteur est intégré dans un émetteur/récepteur d'un système main libre pour une commande à distance (IR ou RF) sur un véhicule automobile. Le signal en sortie du récepteur sert alors par exemple à réveiller le cas échéant l'émission par ledit émetteur/récepteur d'un code d'authentification destiné à commander le verrouillage/déverrouillage du véhicule. Ce réveil intervient lorsque le récepteur détecte un signal radio-fréquence émis par le véhicule, par exemple après détection de la présence d'un individu à proximité d'une portière ou du coffre du véhicule.

## Revendications

1. Récepteur radio-fréquence comportant un oscillateur (1) qui comprend un transistor (T1) qui est commandé par la superposition d'un signal (IC) qui permet le démarrage périodique dudit oscillateur (1), ainsi que d'un signal haute fréquence (RF) à détecter, caractérisé en ce que ce signal périodique (IC) est un signal impulsionnel, l'énergie des impulsions de ce signal étant choisie pour être juste supérieure à l'énergie nécessaire au démarrage de l'oscillateur et en ce qu'il comporte des moyens d'amplification haute fréquence (3) en sortie de l'oscillateur (1), ainsi que des moyens (4) pour restituer la modulation d'amplitude du signal en sortie de ces moyens d'amplification.

2. Récepteur selon la revendication 1, caractérisé en ce qu'il comporte des moyens d'asservissement (5) permettant, en présence d'un signal haute fréquence en sortie des moyens d'amplification, de démarrer plus tôt l'oscillateur.

3. Récepteur selon la revendication 2, caractérisé en ce que les moyens pour restituer la modulation d'amplitude du signal en sortie des moyens d'amplification comportent deux comparateurs (COMP1, COMP2), l'un qui délivre un signal démodulé, l'autre qui délivre un signal qui, en présence d'un signal haute fréquence en sortie des moyens d'amplification, charge un condensateur (C16) que comportent les moyens d'asservissement et qui en l'absence de ce signal haute fréquence décharge ledit condensateur.

4. Récepteur selon l'une des revendications précédentes, caractérisé en ce qu'il comporte un filtre passe bas (R10, C13) en sortie des moyens d'amplification haute fréquence.

5. Récepteur selon l'une des revendications précédentes, caractérisé en ce que les moyens d'amplification (3) sont constitués par un amplificateur à émetteur commun.

6. Récepteur selon l'une des revendications 1 à 4, caractérisé en ce que les moyens d'amplification (3) comportent un montage à deux transistors (T3, T4) auto-polarisés.

7. Récepteur selon l'une des revendications précédentes, caractérisé en ce que le signal périodique impulsionnel présente une période d'une durée de l'ordre de 40 µs à 50 µs.

8. Récepteur selon la revendication 7, caractérisé en ce que la durée d'une impulsion du signal impulsionnel est de l'ordre de 1,5 µs.

9. Récepteur selon l'une des revendications précédentes, caractérisé en ce que le signal périodique impulsionnel est généré par des moyens indépendant de l'oscillateur (1).

10. Système main libre pour une commande à distance sur un véhicule automobile, caractérisée en ce qu'il comporte un récepteur selon l'une des revendications précédentes.
